# EUROPEAN PATENT APPLICATION

(11) **EP 4 796 317 A1**
(43) Date of publication of application: **26.08.2026**
(21) Application number: 25883702.0
(22) Date of filing: 11.03.2025
(51) Int. Cl.: B32B 9/04, B32B 15/20, B32B 3/04, B32B 37/04, B32B 37/06, B32B 37/10, C23C 16/01, C23C 16/26, B22D 19/16

(54) **COMPOSITE THERMAL PAD AND PREPARATION METHOD THEREFOR, AND HEAT DISSIPATION DEVICE**

(30) Priority: 30.12.2024 CN 202411969730
(71) Applicant: Shenzhen HFC Co., Ltd., Guangdong 518103 (CN)
(72) Inventor: LIU, Jinming, Shenzhen, Guangdong 518103 (CN); ZHANG, Jianan, Shenzhen, Guangdong 518103 (CN); SUN, Aixiang, Shenzhen, Guangdong 518103 (CN); CAO, Yong, Shenzhen, Guangdong 518103 (CN); DOU, Lanyue, Shenzhen, Guangdong 518103 (CN)
(74) Representative: Loyer & Abello
(86) International application number: PCT/CN2025/081903
(87) International publication number: WO 2026/143859

(57) **Abstract**

The present disclosure relates to a composite thermal conductive gasket and a preparation method thereof, as well as a heat sink, belonging to the technical field of thermal interface materials. A composite thermal conductive gasket includes: a graphene layer oriented along a thickness direction, wherein the graphene layer has a first surface and a second surface in the thickness direction, and the first surface is configured to adhered to a heat dissipation device; a liquid metal sheet layer, wherein the liquid metal sheet layer is provided on the second surface of the graphene layer and is capable of being bent towards sides of the graphene layer and covering at least part of the sides of the graphene layer, wherein the liquid metal sheet layer, from top to bottom, successively comprises a first alloy layer, an intermediate layer and a second alloy layer, wherein materials of the first alloy layer and the second alloy layer are the same or different, and the intermediate layer is a sheet-like thermal conduct material, and the sheet-like thermal conduct material comprises solid metal foil or a third alloy; and a temperature of a melting point of the intermediate layer is higher than those of the first alloy layer and the second alloy layer. The composite thermal conductive gasket of the present disclosure has high thermal conductivity performance, as well as high compression rate and high reusability.

## Description

### CROSS REFERENCE TO RELATED APPLICATION

The present disclosure claims a priority to the Chinese patent application with the filing No. 2024119697302 filed with the Chinese Patent Office on December 30, 2024, and entitled "COMPOSITE THERMAL CONDUCTIVE GASKET AND PREPARATION METHOD THEREOF, HEAT SINK", which is incorporated herein by reference in entirety.

### TECHNICAL FIELD

The present disclosure relates to a technical field of thermal interface materials, and particularly to a composite thermal conductive gasket and a preparation method thereof, as well as a heat sink.

### BACKGROUND

As the power of chips continues to rise, the requirements for the thermal interface materials between the heat sink probe and the chip are getting higher and higher. Thermal interface materials are key components that connect heat sinks and chips, and their performance directly affects the heat dissipation effect and lifespan of the chips. Before the chips leave the factory, performance tests need to be conducted on them. Therefore, there are high requirements for the thermal conductivity performance and reusability of the thermal interface materials.

At present, the thermal interface materials used in the existing chip testing scenarios mainly include reticulated indium sheets and carbon fiber gaskets, etc. Although these materials have a thermal conductivity performance, their thermal resistance is all above 0.15°C*cm²/W, which is difficult to meet the testing scenarios of high-power chips. At present, the strength and reusability of thermal interface materials with good thermal conductivity performance are relatively poor. However, for thermal interface materials with high reusability, there are deficiencies in their thermal conductivity performance and compressibility. Therefore, many high-performance materials are difficult to meet the requirements for reusable use which leads to the need to replace the interface material each time a test is conducted. This not only increases the testing cost but also wastes time and resources.

### SUMMARY

In view of the deficiencies of the prior art, the objectives of the embodiments of the present disclosure include providing a composite thermal conductive gasket and a preparation method thereof, as well as a heat sink, to have the thermal conductivity performance while improving the compression rate and reusability.

The embodiments of the present disclosure are implemented as follows.

In the first aspect, the present disclosure embodiment provides a composite thermal conductive gasket, which includes: a graphene layer oriented along a thickness direction, wherein the graphene layer has a first surface and a second surface in the thickness direction, and the first surface is configured to adhered to a heat dissipation device; a liquid metal sheet layer, wherein the liquid metal sheet layer is provided on the second surface of the graphene layer and is capable of being bent towards sides of the graphene layer and covering at least part of the sides of the graphene layer, wherein the liquid metal sheet layer, from top to bottom, successively comprises a first alloy layer, an intermediate layer and a second alloy layer, wherein materials of the first alloy layer and the second alloy layer are the same or different, and the intermediate layer is a sheet-like thermal conduct material, and the sheet-like thermal conduct material comprises solid metal foil or a third alloy; and a temperature of a melting point of the intermediate layer is higher than those of the first alloy layer and the second alloy layer .

In the above technical solution, the composite thermal conductive gasket includes a graphene layer oriented along the thickness direction and a liquid metal sheet layer, wherein the graphene layer has a first surface and a second surface in the thickness direction, the first surface is configured to adhere to the heat dissipation device, the liquid metal sheet layer is provided on the second surface of the graphene layer, and after the graphene layer is oriented along the thickness direction, it forms a unidirectional high thermal conductivity material, and at the same time, it has a high compression rate and can significantly absorb a gap tolerance of the contact surface with the heat dissipation device, thereby achieving efficient heat conduction. The liquid metal sheet layer includes alloy layers on the upper and lower surfaces as well as an intermediate layer, the intermediate layer has high strength and can play a supporting role, improving reusability, and at a temperature, the alloy layer on its surface will melt into a liquid state, the fluidity and compressibility in liquid state are much higher than those in solid state, and therefore, after melting, it can achieve a tight bonding with the interface and play a role in filling the gap in interface so as to achieve a reduction in thermal resistance and better heat conduction; therefore, by combining the graphene layer and the liquid metal sheet layer, the present disclosure can improve the thermal conductivity performance while increasing the compression rate and reusability.

In some embodiments of the present disclosure, a temperature difference between the temperature of the melting point of the intermediate layer and the temperature of the melting point of the first alloy layer is at least 50°C; or, the temperature difference between the temperature of the melting point of the intermediate layer and the temperature of the melting point of the second alloy layer is at least 50°C.

By making the temperature of the melting points of the surface layer and the intermediate layer of the liquid metal sheet layer have a temperature difference of at least 50°C, the atomic diffusion ability between the alloy on the surface layer and the metal in the intermediate layer can be weakened, which is conducive to reducing thermal resistance.

In some embodiments of the present disclosure, solid metal foils include one or more of indium foil, platinum foil, copper foil, silver foil, aluminum foil and zinc foil; and/or, the third alloy includes one or more of the Cu-Al alloy, Cu-Sn alloy and Cu-In alloy.

The selection of the above-mentioned solid metal foil or a third alloy can provide good flexibility for the liquid metal sheet layer, and it also has a strength, which can maintain its shape while keeping its thermal conductivity performance; therefore, the liquid metal sheet layer can be bent and perforated to be fixed on the heat dissipation device, so as to better conduct heat and reduce thermal resistance.

In some embodiments of the present disclosure, the material of the first alloy layer or the second alloy layer include phase change alloys or low-melting-point alloys with a temperature of the melting point lower than 160°C.

The material of the first alloy layer or the second alloy layer is a phase change alloy or low-melting-point alloy with a temperature of the melting point below 160°C. It will melt into a liquid state at a temperature, the fluidity and compressibility in liquid state are much higher than those in solid state, and therefore, after melting, it can achieve a tight bonding with the interface and play a role in filling the gap in interface. For example, it can fill the gaps on the surface of the graphene layer so as to achieve a tight bonding with the surface of the graphene layer to better realize heat conduction, thereby reducing thermal resistance. When in contact with the chip, it can simultaneously fill the gaps on the surface of the chip, achieving better contact between the interface material and the surface of the chip, thereby reducing thermal resistance and significantly improving the heat conduction effect.

In some embodiments of the present disclosure, the phase change alloy includes one or more of the Ga-In-Sn alloy, In-Sn-Bi alloy, In-Bi alloy, In-Bi-Ga and Ga-In-Sn-Bi alloy.

All the above-mentioned alloys are phase change alloys with melting points below 160°C, under the bonding force of these phase change alloys, the graphene layer and the liquid metal sheet layer can be closely combined and cannot be easily peeled off. In addition, at a temperature, these alloys can change from solid state to liquid or liquid-solid mixed states, achieving gap filling at the interface and thereby reducing the interface impedance. For instance, the In-Sn-Bi alloy will melt into liquid metal at 60°C, and the liquid metal can achieve a tight bonding with the interface in contact, thereby reducing thermal resistance.

In some embodiments of the present disclosure, the thickness of the liquid metal sheet layer is 20-200µm, wherein the thicknesses of the first alloy layer and the second alloy layer are similar, and are 5-50µm.

In the liquid metal sheet layer, the first alloy layer and the second alloy layer mainly fill the gaps in the interface. Within the above-mentioned thickness range, effective filling of gaps can be achieved, and the heat conduction effect is improved. The intermediate layer has high strength and mainly serves a supporting function. Therefore, the intermediate layer is relatively thicker than the surface layers, which is more beneficial to provide support, and thereby improving reusability. Controlling the thickness of the liquid metal sheet layer within 20-200µm is beneficial to reduce thermal resistance. When the thickness of the liquid metal sheet layer is less than 20µm, due to the thinness of the liquid metal sheet layer, the surface is not flat and smooth enough, which is prone to wrinkles and leads to poor contact. When the thickness exceeds 200µm, the intermediate layer will warp due to its high modulus, which will increase thermal resistance.

In some embodiments of the present disclosure, the thickness of the graphene layer is 0.3-3mm.

In case the thickness of the graphene layer is within the above-mentioned range, the graphene layer can not only provide high thermal conductivity performance for this composite thermal conductive gasket, but also provide a high compression rate.

In some embodiments of the present disclosure, the liquid metal sheet layer covers a part or all of the sides.

In some embodiments of the present disclosure, the liquid metal sheet layer further covers a part or all of the first surface.

Covering the first surface of the graphene layer with a liquid metal sheet layer enables the first surface of the graphene layer to adhere to the heat dissipation device through the liquid metal sheet layer, which can reduce the contact thermal resistance between the graphene layer and the heat dissipation device and further improve the heat conduction efficiency.

In some embodiments of the present disclosure, a side of the liquid metal sheet layer away from the second surface is provided with a copper plating layer or an aluminum plating layer.

Providing a side of the liquid metal sheet layer away from the second surface with a copper plating layer or an aluminum plating layer allows the liquid metal sheet layer capable of contacting the chip through the copper plating layer or aluminum plating layer, which not only can dissipate heat from the chip but also can reduce the probability of the surface alloy material of the liquid metal sheet layer reacting with the materials such as gold the surface of the chip, thereby increasing the service life of the chip.

In the second aspect, the embodiment of the present disclosure provides a preparation method for a composite thermal conductive gasket, including: growing graphene on metal foils by chemical vapor deposition, and after the growth is completed, peeling off the graphene from the metal foils and stacking the graphene longitudinally to obtain the graphene layer oriented along the thickness direction; heating and melting the material of the first alloy layer and the material of the second alloy layer to form liquid metal, coating the liquid metal on opposite sides of a sheet-like thermal conductive material of the intermediate layer to form the first alloy layer and the second alloy layer, and then rolling an entire piece to obtain the liquid metal sheet layer; and heating the liquid metal sheet layer so that the first alloy layer or the second alloy layer on a surface of the liquid metal sheet layer is in a molten state, then placing the graphene layer above the liquid metal sheet, and applying pressure to make the graphene layer closely contact the liquid metal sheet layer and pushing and pressing, after cooling under maintained pressure, obtaining the composite thermal conductive gasket.

In the above-mentioned technical solution, the grown graphene is peeled off from the metal foil and stacked longitudinally to form graphene oriented along the thickness direction, and this orientation enhances the heat conduction path of the graphene and improves the heat conduction efficiency; then, by heating and melting the materials of the first alloy layer and the second alloy layer to form liquid metal and coating it on the opposite sides of the sheet-like thermal conductive material in the intermediate layer, the high fluidity of the liquid metal enables it to penetrate into the microstructure of the sheet-like thermal conductive material, making the combination of the intermediate layer with the first alloy layer and the second alloy layer more firm and forming a liquid metal sheet layer; furthermore, after heating the first or second alloy layer on the surface of the liquid metal sheet layer to a molten state, applying pressure to make the graphene layer closely contact the liquid metal sheet layer, and then combining them by pushing and pressing, and then cooling under maintained pressure, it helps to form a stable interface structure, thereby improving the stability and durability of the composite thermal conductive gasket.

In some embodiments of the present disclosure, after being rolled, the thickness of the first alloy layer formed is 5-50µm, and the thickness of the second alloy layer is 5-50µm; or/and, metal foils include one or more of copper foil, nickel foil, magnesium foil, iron foil, steel foil and titanium foil.

Setting the thicknesses of the first alloy layer and the second alloy layer at 5-50µm can achieve a good gap filling effect. The use of the above-mentioned metal foils is more conducive to the growth of graphene. For instance, copper foils and nickel foils not only have a high thermal conductivity, which can effectively conduct heat, but also possess high strength and rigidity, providing a stable substrate and making graphene less prone to deformation or damage during growth and post-processing.

In some embodiments of the present disclosure, the applied pressure is 20-30psi and the speed of pushing and pressing is 0.8-1.2mm/s.

By controlling the pressure at 20-30psi and the speed of pushing and pressing at 0.8-1.2mm/s, the thicknesses of the graphene layer and the liquid metal sheet layer can be effectively controlled, thereby effectively reducing the thermal resistance.

In the third aspect, the embodiments of the present disclosure provide a heat sink, which includes a heat dissipation device and any of the above-mentioned composite thermal conductive gasket, wherein the first surface of the composite thermal conductive gasket is adhered to the heat dissipation device.

In the above technical solution, the heat sink is adhered to the composite thermal conductive gasket of the present disclosure, wherein, the first surface of the composite thermal conductive gasket is adhered to the heat dissipation device, that is to say, the graphene side of the composite thermal conductive gasket is closely adhered to the heat dissipation device. The high thermal conductivity of graphene enables heat to be rapidly transferred to the heat dissipation device. This significantly reduces thermal resistance, improves heat dissipation efficiency, and ultimately achieves a goal of rapid heat dissipation.

In some embodiments of the present disclosure, in the heat sink, the liquid metal sheet layer covers the second surface and the sides of the graphene layer and extends outward, and two extended ends of the liquid metal sheet layer are respectively detachably connected to opposite sides of the heat dissipation device.

The liquid metal sheet layer covers the second surface and the sides of the graphene layer and extends outward, that is to say, the liquid metal sheet layer covers the periphery part of the graphene layer, which not only protects the graphene layer but also enhances the interface bonding ability between the graphene layer and the heat dissipation device, thereby reducing thermal resistance and improving heat dissipation efficiency. In addition, the two extended ends of the liquid metal sheet layer are respectively detachably connected to the opposite sides of the heat dissipation device respectively, and due to the high flexibility of the liquid metal sheet layer, the composite thermal conductive gasket can be bent and perforated, and thus can be firmly fixed on the heat dissipation device.

In some embodiments of the present disclosure, in the heat sink, liquid metal sheet layer covers the second surface, the sides and at least part of the first surface of the graphene layer, and the liquid metal sheet layer further extend outward along the sides, and the two extended ends of the liquid metal sheet layer are respectively detachably connected to the opposite sides of the heat dissipation device.

The liquid metal sheet layer covers the periphery part of the graphene layer, which can protect the graphene layer. Moreover, the first surface of the graphene layer is adhered to the heat dissipation device through the liquid metal sheet layer, which can enhance the interface bonding ability between the graphene layer and the heat dissipation device, thereby reducing the contact thermal resistance and improving the heat dissipation efficiency. In addition, the two ends of the liquid metal sheet layer extending from the sides are respectively detachably connected to the opposite sides of the heat dissipation device. Due to the high flexibility of the liquid metal sheet layer, this composite thermal conductive gasket can be bent and perforated, thereby enabling the composite thermal conductive gasket to be firmly fixed on the heat dissipation device.

### BRIEF DESCRIPTION OF DRAWINGS

In order to more clearly illustrate technical solutions of embodiments of the present disclosure, drawings that need to be used in the embodiments will be briefly introduced below. It should be understood that the drawings only show some embodiments of the present disclosure, and thus should not be regarded as limitation to the scope. Those ordinarily skilled in the art could also obtain other relevant drawings based on these drawings without using any inventive efforts.
FIG. 1 is a structural schematic diagram of a composite thermal conductive gasket of the present disclosure;
FIG. 2 is a first structural schematic diagram of a heat sink of the present disclosure;
FIG. 3 is a second structural schematic diagram of the heat sink of the present disclosure;
FIG. 4 is a schematic diagram of the application scenarios of the composite thermal conductive gasket of the present disclosure.

Reference signs: 101- first alloy layer; 102- intermediate layer; 103- second alloy layer; 104- plating layer; 200- graphene layer; 300- heat dissipation device; 400- screw; 500- chip.

### DETAILED DESCRIPTION OF EMBODIMENTS

In order to make objectives, technical solutions and advantages of embodiments of the present disclosure clearer, the technical solutions in the embodiments of the present disclosure will be described clearly and completely below. Where no specific conditions are specified in the embodiments, the conventional conditions or the conditions recommended by the manufacturer shall be followed. Reagents or instruments used without specified manufacturers are all conventional products that can be purchased through the market.

The following is a detailed description of a composite thermal conductive gasket and a preparation method thereof, as well as a heat sink of an embodiment of the present disclosure.

The embodiment of the present disclosure provides a composite thermal conductive gasket, including: a graphene layer 200 oriented along a thickness direction, wherein the graphene layer 200 has a first surface and a second surface in the thickness direction, and the first surface is configured to adhere to a heat dissipation device 300; and a liquid metal sheet layer, wherein the liquid metal sheet layer is provided on the second surface of the graphene layer 200 and can be bent towards sides of the graphene layer 200 and cover at least part of the sides of the graphene layer 200. The liquid metal sheet layer, from top to bottom, successively includes a first alloy layer 101, an intermediate layer 102 and a second alloy layer 103, wherein the materials of the first alloy layer 101 and the second alloy layer 103 are the same or different, the intermediate layer 102 is a sheet-like thermal conductive material, and the sheet-like thermal conductive material includes solid metal foil or a third alloy, and wherein a temperature of a melting point of the intermediate layer 102 is higher than those of the first alloy layer 101 and the second alloy layer 103.

In the present disclosure, "cover at least part of the sides of the graphene layer 200" means that the liquid metal sheet layer 200 can cover a part of the sides of the graphene layer 200, or the liquid metal sheet layer 200 can cover the entire sides of the graphene layer 200.

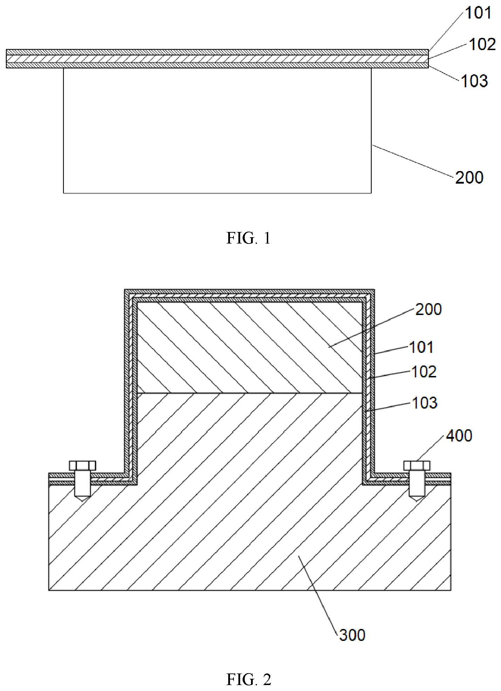

As shown in FIGS. 1 and 2, the composite thermal conductive gasket includes a graphene layer 200 oriented along a thickness direction and a liquid metal sheet layer, wherein the graphene layer 200 has a first surface and a second surface in the thickness direction, the first surface is configured to adhere to the heat dissipation device 300, the liquid metal sheet layer is provided on the second surface of the graphene layer 200, and after the graphene layer 200 is oriented along the thickness direction, it forms a unidirectional high thermal conductivity material, and at the same time, it has a high compression rate, which enables the composite thermal conductive gasket to have a high compression rate, which can significantly absorb a gap tolerance of contact surfaces with the heat dissipation device 300, thereby achieving efficient heat conduction.

By further referring to FIG. 1, it can be seen that the liquid metal sheet layer can be bent towards the sides of the graphene layer 200 and cover at least part of the sides of the graphene layer 200, on the one hand, to protect the graphene. On the other hand, since the first surface of graphene is adhered to the heat dissipation device 300, that is, the heat dissipation device 300 is located beneath the liquid metal sheet layer. Thanks to a high flexibility of the liquid metal sheet layer, it can be bent. Therefore, the liquid metal sheet layer can be made into a bent and perforated shape, allowing the liquid metal sheet layer to cover the second surface and two sides of graphene, and holes are drilled at the end of the part of the liquid metal sheet layer extending to the sides of the graphene, thereby fixing the liquid metal sheet layer on the heat dissipation device 300, which is conducive to better heat conduction.

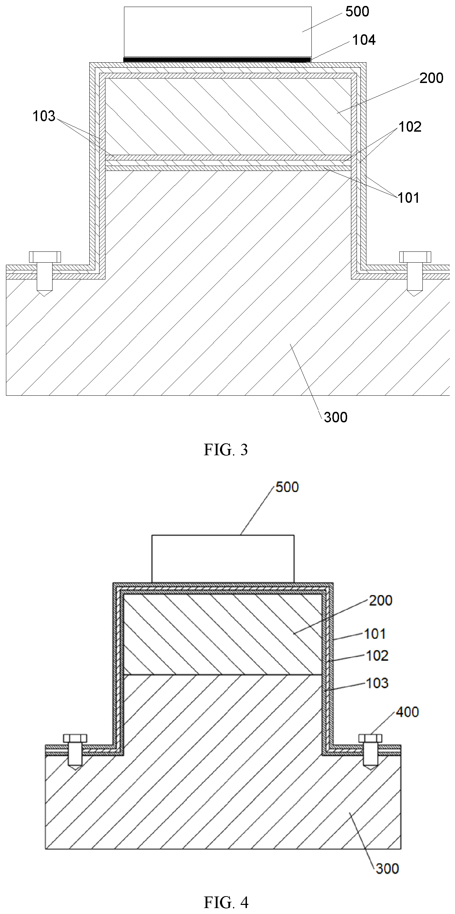

Alternatively, referring to FIG. 3, the liquid metal sheet layer is bent towards the sides of the graphene layer 200 to cover the sides of the graphene layer 200 and extends outward along the direction of the sides. The two extended ends of the liquid metal sheet layer are respectively detachably connected to the opposite sides of the heat dissipation device. Moreover, at the first surface of the graphene layer 200, there is also a liquid metal sheet layer covered. The graphene layer 200 is adhered to the heat dissipation device 300 through the liquid metal sheet layer, which is conducive to better heat conduction.

In the present disclosure, the liquid metal sheet layer covering the first surface and the liquid metal sheet layer covering the sides and the first surface can be an integral structure or a split structure. The first surface of the graphene layer 200 can come into contact with the first alloy layer 101 of the liquid metal sheet layer and also with the second alloy layer 103, which is not limited in the present disclosure. In the present disclosure, the liquid metal sheet layer can cover a part of the first surface of the graphene layer 200 or the entire first surface of the graphene layer 200, which is not limited in the present disclosure.

This liquid metal sheet layer is of a sandwich structure, having the same first alloy layer 101 and second alloy layer 103, and an intermediate layer 102 of a sheet-like thermal conductive material, wherein the sheet-like thermal conductive material includes a solid metal foil or a third alloy. The intermediate layer 102 of this sandwich structure has high strength and can play a supporting role, improving reusability, and the alloy layer on a surface of the intermediate layer will melt into a liquid state at a temperature, the fluidity and compressibility in liquid state are much higher than those in solid state, and therefore after melting, it can achieve close bonding with the interface and play a role of filling the interface, thereby reducing thermal resistance and achieving better heat conduction. Therefore, thanks to the high performance and high strength of the sandwich structure of the liquid metal sheet, the reusability of this thermal conductive gasket has been improved.

In the embodiments of the present disclosure, the temperature difference between a melting point of the intermediate layer 102 and that of the first alloy layer 101 is at least 50°C. Alternatively, the temperature difference between the melting point of the intermediate layer 102 and that of the second alloy layer 103 is at least 50°C.

That is to say, the temperature of the melting point of the surface layer of the liquid metal sheet layer is at least 50°C lower than the melting point of the intermediate layer 102. By providing such a difference in melting points, the atomic diffusion ability between the alloy on the surface layer and the metal in the intermediate layer 102 can be weakened. If the melting points of the surface layer and the intermediate layer 102 are close, there may be a situation where atoms in different layers are very active during the working process, and the atoms are prone to mutual diffusion, causing the melting point of the metal in the surface layer to rise, which in turn leads to an increase in thermal resistance.

As an example, the temperature difference differences between the melting point of the intermediate layer 102 and that of the first alloy layer 101 include but are not limited to 50°C, 55°C, 60°C, 70°C, 80°C, 100°C, 110°C and 120°C.

As an example, solid metal foils include but are not limited to one or more of indium foil, platinum foil, copper foil, silver foil, aluminum foil and zinc foil, and the third alloy includes but is not limited to one or more of the Cu-Al alloy, Cu-Sn alloy and Cu-In alloy.

The materials of the first alloy layer 101 or the second alloy layer 103 include but are not limited to phase change alloys or low-melting-point alloys with a temperature of the melting point lower than 160°C. As an example, the materials of the first alloy layer 101 or the second alloy layer 103 independently include but are not limited to one or more of the Ga-In-Sn alloy, In-Sn-Bi alloy, In-Bi alloy, In-Bi-Ga and Ga-In-Sn-Bi alloy.

The materials of the first alloy layer 101 or the second alloy layer 103 can be the same or different. For example, the material of the first alloy layer 101 and the material of the second alloy layer 103 are both Ga-In-Sn-Bi. Alternatively, as an example, the material of the first alloy layer 101 is Ga-In-Sn-Bi, and the material of the second alloy layer 103 is In-Sn-Bi alloy.

For example, the melting point of the first alloy layer 101 is lower than that of the second alloy layer 103. The melting point of the first alloy layer 101 is relatively low, and when in contact with heat sources such as chip 500, the first alloy layer 101 can melt at a lower temperature, filling the interface between the liquid metal sheet layer and the heat source.

Further, as an example, continuing to refer to FIG. 3, a side of the liquid metal sheet layer away from the second surface is provided with a plating layer 104, wherein the plating layer 104 can be a copper plating layer or an aluminum plating layer. For instance, when the second alloy layer 103 of the liquid metal layer contacts the second surface of the graphene layer 200, a copper or aluminum plating layer can be provided on the side of the first alloy layer 101 of the liquid metal layer away from the second alloy layer 103. The composite thermal conductive gasket provided in the embodiment of the present disclosure is configured to dissipate heat from heat sources such as chip 500, and a copper or aluminum plating layer is provided between chip 500 and the first alloy layer 101, which can reduce the probability of the reaction between the gold and other materials on the surface of chip 500 and the alloy materials of the first alloy layer 101, and increase the service life of chip 500.

In the present disclosure, a thickness of the liquid metal sheet layer is 20-200µm, in which the thicknesses of the first alloy layer 101 and the second alloy layer 103 are similar, and are 5-50µm.

That is to say, the thickness of the intermediate layer 102 is 10-190µm, for example, the thickness of the intermediate layer 102 includes but is not limited to 10µm, 20µm, 30µm, 40µm, 50µm, 55µm, 60µm, 65µm, 70µm, 75µm, 80µm, 85µm, 90µm, 95µm, 100µm, 110µm, 120µm, 130µm, 140µm, 150µm, 160µm, 170µm, 180µm or 190µm.

The thicknesses of the first alloy layer 101 and the second alloy layer 103 being similar means that the thickness of the first alloy layer 101 and the thickness of the second alloy layer 103 is the same within the above range, or the thickness of the first alloy layer 101 and the thickness of the second alloy layer 103 is not the same within the above range. For example, the thicknesses of the first alloy layer 101 and the second alloy layer 103 are independent of each other, including but not limited to 5µm, 6µm, 7µm, 8µm, 9µm, 10µm, 11µm, 12µm, 13µm, 14µm, 15µm, 16µm, 17µm, 18µm, 19µm, 20µm, 25µm, 30µm, 35µm, 40µm, 45µm or 50µm.

In the present disclosure, the thickness of the graphene layer 200 is 0.3-3mm.

For example, the thickness of the graphene layer 200 includes but is not limited to 0.3mm, 0.5mm, 0.8mm, 1mm, 1.3mm, 1.7mm, 2mm, 2.2mm, 2.6mm, 2.8mm, 3mm.

The following describes the preparation method of the above-mentioned composite thermal conductive gasket.

A preparation method of a composite thermal conductive gasket, including the following steps.
(1) Preparation of graphene layer 200
   growing graphene on metal foils by chemical vapor deposition (CVD), and then peeling off the graphene from the metal foils and stacking the graphene longitudinally to obtain the graphene layer 200 oriented along the thickness direction.
   Metal foils include but are not limited to one or more of copper foil, nickel foil, magnesium foil, iron foil, steel foil and titanium foil.
(2) Preparation of liquid metal sheet layer
   heating and melting the material of the first alloy layer 101 and the material of the second alloy layer 103 to form liquid metal, coating the liquid metal on the opposite sides of a sheet-like thermal conductive material of the intermediate layer 102 to form the first alloy layer 101 and the second alloy layer 103, and then pushing and pressing the entire piece to obtain the liquid metal sheet layer.

After being rolled, the thickness of the first alloy layer 101 formed is 5-50µm, and the thickness of the second alloy layer 103 is 5-50µm.

The first alloy layer 101 and the second alloy layer 103 mainly serve to fill the gap, therefore if they are too thin, they cannot achieve the effect of filling the gap, or if they are too thick, they will overflow during the subsequent rolling process, thereby affecting the heat conduction effect. Therefore, the thicknesses of the first alloy layer 101 and the second alloy layer 103 are set at 5-50µm, which not only can achieve the effect of filling the gap but also is conducive to heat conduction.

(3) Combining graphene layer 200 and liquid metal sheet layer
heating the liquid metal sheet layer in step (2) so that the first alloy layer 101 or the second alloy layer 103 on the surface layer of the liquid metal sheet layer is in a molten state, then placing the graphene layer 200 in step (1) above the liquid metal sheet layer, applying pressure to make the graphene layer 200 closely contact the liquid metal sheet layer, and pushing and pressing, and after cooling under maintained pressure, obtaining the composite thermal conductive gasket.

Furthermore, after placing the graphene layer 200 from step (1) above the liquid metal sheet layer and completing the pushing and pressing, attaching a liquid metal sheet layer prepared in step (2) to the first surface of the graphene layer 200 and heating, and applying pressure to the liquid metal sheet layer to make the graphene layer 200 in close contact with the liquid metal sheet layer and then pushing and pressing it, and after cooling under maintained pressure, obtaining a composite thermal conductive gasket with graphene layer 200 covered with liquid metal sheet layers on both surfaces.

Furthermore, a plating layer 104 can be plated on a side of the liquid metal sheet layer away from the second surface. The plating layer 104 can be a copper plating layer or an aluminum plating layer. The plating methods can adopt magnetron sputtering or electron beam evaporation.

In the preparation of liquid metal sheet layer, the applied pressure is 20-30psi, and the pushing and pressing speed is 0.8-1.2mm/s.

By applying pressure for pushing and pressing, the thickness of each layer in graphene and liquid metal sheet layer can be effectively controlled, controlling the thickness of graphene at 0.3-3mm and the thickness of liquid metal sheet layer at 20-200µm, wherein the thicknesses of the first alloy layer 101 and the second alloy layer 103 are similar, and are 5-50µm. By controlling the pressure and speed of pushing and pressing within the above-mentioned range, the thickness of the composite thermal conductive gasket can be effectively adjusted, thereby effectively reducing the thermal resistance. The embodiments of the present disclosure further provide a heat sink, including a heat dissipation device 300 and any of the above-mentioned composite thermal conductive gaskets, wherein the first surface of the composite thermal conductive gasket is adhered to the heat dissipation device 300.

As shown in FIG. 2, the graphene layer 200 is covered by a liquid metal sheet layer. The first surface of the graphene layer 200 is adhered to the heat dissipation device 300, and the second surface is closely bonded to the liquid metal sheet layer.

Continuing to refer to FIG. 2, the liquid metal sheet layer covers the second surface and sides of the graphene layer 200 and extends outward, and the two extended ends of the liquid metal sheet layer are respectively detachably connected to the opposite sides of the heat dissipation device 300.

Alternatively, continuing to refer to FIG. 3, the liquid metal sheet layer covers the second surface and sides of the graphene layer 200 and extends outward, and the two extended ends of the liquid metal sheet layer are respectively detachably connected to the opposite sides of the heat dissipation device 300. Moreover, the liquid metal sheet layer is further provided between the first surface of the graphene layer 200 and the heat dissipation device 300.

The composite thermal conductive gasket of the present disclosure has the advantages of high strength and good flexibility. Therefore, it can be bent and perforated according to the shape of the heat dissipation device 300, and then fixed with screws or other fixing components. The operation is simple and takes a short time.

For example, the liquid metal sheet layer can be fixed on the heat dissipation device 300 by means such as screw 400 (as shown in FIG. 4).

The heat sink of the present disclosure can be configured for heat dissipation of chip 500, and usage schematic diagram of which is shown in FIG. 4. As can be seen from FIG. 4, the graphene layer 200 at a bottom of the composite thermal conductive gasket is in contact with the heat dissipation device 300, and the liquid metal sheet layer at the top is in contact with the chip 500. The alloy layer on the surface of the liquid metal sheet layer is not easily damaged during the contact and separation process with the chip 500 due to a small bonding force. On the other surface, it is closely combined with the graphene gasket, so it can maintain a low thermal resistance during reused use. Moreover, the graphene layer 200 can be repeatedly tested without damage due to the support and protection of the liquid metal sheet layer. After the alloy layer on the surface layer of the liquid metal sheet layer is repleted tested many times, the surface will gradually be contaminated by impurities or slightly oxidized, resulting in performance degradation. When the degradation reaches an unusable value, a simple replacement can be carried out.

Furthermore, when the surface of the chip 500 is provided with a gold plating layer, the liquid metal sheet layer on the top of the composite thermal conductive gasket contacts the chip 500 through the plating layer 104 such as the copper plating layer or aluminum plating layer, preventing the materials such as gold on the surface of the chip 500 from directly contacting and reacting with the alloy materials on the surface layer of the liquid metal sheet layer.

The following provides a further detailed description of the features and performance of the present disclosure in combination with the embodiments.

### Embodiment 1

This embodiment provides a composite thermal conductive gasket, including the following steps.
(1) Preparation of graphene layer 200
   growing graphene on copper foil by chemical vapor deposition (CVD), then peeling off the graphene from the copper foil and stacking the graphene longitudinally to obtain graphene layer 200 oriented along the thickness direction, and controlling the thickness of the graphene layer 200 at 0.3mm.
(2) Preparation of liquid metal sheet layer
   weighing the material according to a ratio of In-32wt.%Bi-16.5wt.%Sn (that is, a mass ratio of In is 51.5%, a mass ratio of Bi is 32%, and a mass ratio of Sn is 16.5%), and then heating and melting to form liquid metal; coating the liquid metal on the opposite sides of the copper foil of 0.05mm thick; forming the first alloy layer 101 with a thickness of 0.015mm and the second alloy layer 103 with a thickness of 0.015mm respectively; subsequently, rolling and flattening the entire piece on a hot roller to achieve the uniformity of the thickness of the liquid metal sheet layer, resulting in a liquid metal sheet layer with a total thickness of 0.08mm and a single-sided thickness of the surface layer of 0.015mm.
(3) Combining graphene layer 200 and liquid metal sheet layer
   placing the liquid metal sheet layer in step (2) on a heating table for heating, so that the first alloy layer 101 or the second alloy layer 103 on the surface layer of the liquid metal sheet layer is in a molten state; then placing the graphene layer 200 in step (1) above the liquid metal sheet layer and applying a pressure of 30psi to make the graphene layer 200 in close contact with the liquid metal sheet layer; and pushing and pressing at a pressure of 1.0mm/s, after cooling under maintained pressure, obtaining the composite thermal conductive gasket.

### Embodiment 2

This embodiment is basically the same as Embodiment 1, with the difference being that the thickness of the graphene layer 200 is 0.5mm.

### Embodiment 3

This embodiment is basically the same as Embodiment 1, with the difference being that a copper foil of 0.12mm thick is selected, and the total thickness of the final liquid metal sheet layer is 0.15mm.

### Embodiment 4

This embodiment is basically the same as Embodiment 1, with the difference being that the thickness of the graphene layer 200 is 0.4mm.

### Embodiment 5

This embodiment is basically the same as Embodiment 1, with the difference being that the total thickness of the liquid metal sheet layer is 0.11mm, and a copper foil of 0.08mm thick is selected, that is to say, the thickness of the intermediate layer 102 is 0.08mm.

### Embodiment 6

This embodiment is basically the same as Embodiment 1, with the difference being that the total thickness of the liquid metal sheet layer is 0.06mm, and a copper foil of 0.03mm thick is selected, that is to say, the thickness of the intermediate layer 102 is 0.03mm.

### Embodiment 7

This embodiment is basically the same as Embodiment 1, with the difference being that liquid metal is coated on opposite sides of a copper foil of 0.02mm thick to form a first alloy layer 101 with a thickness of 0.025mm and a second alloy layer 103 with a thickness of 0.015mm, respectively.

### Embodiment 8

This embodiment is basically the same as Embodiment 1, with the difference being that the liquid metal composition of the alloy layer on a side of the liquid metal sheet layer away from the graphene layer 200 is In-33wt.%Bi alloy. That is, the composition of the first alloy layer 101 is In-33wt.%Bi alloy, and the composition of the second alloy layer 103 is consistent with that of Embodiment 1.

### Embodiment 9

This embodiment is basically the same as Embodiment 1, with the difference being that the liquid metal sheet layer is single-sided copper plated on one side away from the graphene layer 200.

### Embodiment 10

This embodiment is basically the same as Embodiment 1, with the difference being that the liquid metal sheet layer is single-sided indium plated on the side away from the graphene layer 200.

### Embodiment 11

This embodiment is basically the same as Embodiment 1, with the difference being: in step (3), placing the liquid metal sheet layer in step (2) on the heating table for heating, so that the first alloy layer 101 or the second alloy layer 103 on the surface layer of the liquid metal sheet layer is in a molten state; then, placing the graphene layer 200 in step (1) above the liquid metal sheet layer; applying a pressure of 30psi to make the graphene layer 200 in close contact with the liquid metal sheet layer, pushing and pressing at a pressure of 1.0mm/s, and maintaining the pressure and cooling it; bending the liquid metal sheet layer and covering the sides of the graphene layer 200; adhering a liquid metal sheet layer to the first surface of the graphene layer 200, heating, applying a pressure of 30psi to make the graphene layer 200 in close contact with the liquid metal sheet layer, pushing and pressing at a pressure of 1.0mm/s, maintaining the pressure and cooling it; and obtaining a composite thermal conductive gasket with the first surface, sides and second surface of graphene layer 200 all covered with liquid metal graphene sheet layers.

### Comparative example 1

The comparative example is basically the same as that of Embodiment 1, with the difference being that the liquid metal sheet layer is replaced with copper foil of the same thickness.

### Comparative example 2

The comparative example is basically the same as that of Embodiment 1, with the difference being that the liquid metal sheet layer is replaced with a reticulated indium sheet of the same thickness.

### Comparative example 3

The comparative example is pure graphene with a thickness of 0.3mm.

### Comparative example 4

The comparative example is basically the same as that of Embodiment 1, with the difference being that there is no graphene layer 200, and only a liquid metal sheet layer is used as the thermal conductive gasket.

The comparative example provides a composite thermal conductive gasket, including the following steps:
weighing the material according to the ratio of In-32wt.%Bi-16.5wt.%Sn, and then heating and melting to form liquid metal; coating the liquid metal on the opposite sides of the copper foil of 0.05mm thick to form the first alloy layer 101 with a thickness of 0.015mm and the second alloy layer 103 with a thickness of 0.015mm respectively; subsequently, rolling and flattening the entire piece on a hot roller to achieve uniformity in the thickness of the liquid metal sheet layer, resulting in a liquid metal sheet layer with a total thickness of 0.08mm and a single-sided thickness of the surface layer of 0.015mm.

Some parameters of the above-mentioned embodiments and the comparative examples are detailed in Table 1.

**Table 1**

| Group | liquid metal sheet layer | | | thickness of graphene layer 200 (mm) |
|---|---|---|---|---|
| | thickness of first alloy layer 101 (mm) | thickness of intermediate layer 102 (mm) | thickness of second alloy layer 103 (mm) | |
| Embodiment 1 | 0.015 | 0.05 | 0.015 | 0.3 |
| Embodiment 2 | 0.015 | 0.05 | 0.015 | 0.5 |
| Embodiment 3 | 0.015 | 0.12 | 0.015 | 0.3 |
| Embodiment 4 | 0.015 | 0.05 | 0.015 | 0.4 |
| Embodiment 5 | 0.015 | 0.08 | 0.015 | 0.3 |
| Embodiment 6 | 0.015 | 0.03 | 0.015 | 0.3 |
| Embodiment 7 | 0.025 | 0.02 | 0.015 | 0.3 |
| Embodiment 8 | the alloy layer of the side of the liquid metal sheet layer away from the graphene layer 200 is In-33wt%Bi | | | |
| Embodiment 9 | the liquid metal sheet layer is single-sided copper plated on one side away from the graphene layer 200 | | | |
| Embodiment 10 | the liquid metal sheet layer is single-sided indium plated on the side away from the graphene layer 200 | | | |
| Embodiment 11 | the sides, first surface, and second surface of graphene layer 200 are all covered with liquid metal sheet layer | | | |
| Comparative example 1 | the liquid metal sheet layer is replaced with copper foil of the same thickness | | | |
| Comparative example 2 | the liquid metal sheet layer is replaced with a reticulated indium sheet of the same thickness | | | |
| Comparative example 3 | / | / | / | 0.3 |
| Comparative example 4 | 0.015 | 0.05 | 0.015 | / |

### Test example

This test example measures the performance of the materials prepared in Embodiments 1-11 and Comparative examples 1-4, including the measurement of contact thermal resistance and cost-performance index.

The method for measuring the contact thermal resistance is as follows. The materials prepared in Embodiments 1-11 and Comparative example 1-4 are respectively cut into sheets of 30*30mm in size, and then placed on a thermal resistance meter (Long Win Science & Technology Corporation LW9389) for testing. The test temperature is 80°C and the pressure is 10-50psi, and the measurement is carried out in accordance with the ASTM D5470 standard.

Defining the cost-performance index: at a chip testing end, performance takes priority (low thermal resistance), followed by gap tolerance filling and a number of repetitions. High-power chip testing requires a thermal resistance of less than 0.15°C*cm²/W, while conventional chip testing requires a thermal resistance of 0.25°C*cm²/W. In a supposed high-power chip testing scenario, with a weight of the material performance being 0.4, a score is 100 when a thermal resistance is below 0.15°C*cm²/W, and the score is 0 when the thermal resistance is higher than 0.5°C*cm²/W; with the weight of the compression rate being set to 0.3, a score is 100 when the compression rate is over 50% at 50psi, and a score is 0 when the compression rate is below 20% at 50psi; with the weight of the number of repetitions being 0.3, a score is 100 when the number of repetitions is 100, and the score is 0 when the number of repetitions is less than 10. Then the cost-performance index of Embodiment 1 is calculated as follows: the score of the performance index is 40, the score of the compression index is 49.5/50*100*0.3=29.7, the score of the repetition index is 20/100*100*0.3=6, and the total score is 75.7. The score of the cost-performance for Comparative example 2 is calculated as follows: the score of the performance index is 0.15/0.4*100*0.4=15, the score of the compression index is 46.9/50*100*0.3=28.1, the score of the repetition index is 80/100*100*0.3=24, and the total score is 67.1. The calculations of other cases are shown in Table 2.

**Table 2**

| Group | Pressure /Psi | Thermal resistance/°C·cm²/W | Total thickness of composite gasket/mm | Compress ion rate/% | Number of reusability | Thermal resistance after repetitions (°C·cm²/W) | Score of the cost-perfor mance |
|---|---|---|---|---|---|---|---|
| Embodiment 1 | 10 | 0.083 | 0.336 | 11.6 | >20 times | <0.1 | 75.7 |
| | 20 | 0.075 | 0.311 | 18.2 | | | |
| | 30 | 0.07 | 0.24 | 36.8 | | | |
| | 40 | 0.067 | 0.209 | 45.0 | | | |
| | 50 | 0.065 | 0.192 | 49.5 | | | |
| Embodiment 2 | 10 | 0.128 | 0.35 | 7.9 | >20 times | <0.15 | 72.6 |
| | 20 | 0.105 | 0.33 | 13.2 | | | |
| | 30 | 0.092 | 0.267 | 29.7 | | | |
| | 40 | 0.089 | 0.239 | 40.3 | | | |
| | 50 | 0.088 | 0.223 | 44.3 | | | |
| Embodiment 3 | 10 | 0.162 | 0.369 | 7.8 | >20 times | <0.15 | 69.4 |
| | 20 | 0.126 | 0.336 | 16.0 | | | |
| | 30 | 0.105 | 0.269 | 32.8 | | | |
| | 40 | 0.093 | 0.255 | 36.3 | | | |
| | 50 | 0.085 | 0.244 | 39.0 | | | |
| Embodiment 4 | 10 | 0.15 | 0.315 | 21.3 | >20 times | <0.15 | 73.7 |
| | 20 | 0.095 | 0.295 | 26.3 | | | |
| | 30 | 0.091 | 0.273 | 31.8 | | | |
| | 40 | 0.84 | 0.227 | 40.3 | | | |
| | 50 | 0.080 | 0.205 | 46.1 | | | |
| Embodiment 5 | 10 | 0.137 | 0.367 | 10.5 | >20 times | <0.15 | 71.4 |
| | 20 | 0.103 | 0.340 | 17.1 | | | |
| | 30 | 0.092 | 0.3 | 26.8 | | | |
| | 40 | 0.084 | 0.264 | 35.6 | | | |
| | 50 | 0.075 | 0.236 | 42.4 | | | |
| Embodiment 6 | 10 | 0.151 | 0.315 | 10.0 | >15 times | <0.15 | 74.5 |
| | 20 | 0.119 | 0.291 | 16.9 | | | |
| | 30 | 0.084 | 0.208 | 40.6 | | | |
| | 40 | 0.057 | 0.176 | 49.7 | | | |
| | 50 | 0.056 | 0.158 | 54.9 | | | |
| Embodiment 7 | 10 | 0.152 | 0.315 | 9.8 | >15 times | <0.15 | 74.5 |
| | 20 | 0.121 | 0.291 | 16.6 | | | |
| | 30 | 0.086 | 0.208 | 39.3 | | | |
| | 40 | 0.059 | 0.176 | 48.9 | | | |
| | 50 | 0.056 | 0.158 | 54.7 | | | |
| Embodiment 8 | 10 | 0.104 | 0.315 | 10.1 | >20 times | <0.15 | 76 |
| | 20 | 0.079 | 0.291 | 17.0 | | | |
| | 30 | 0.052 | 0.208 | 42.1 | | | |
| | 40 | 0.044 | 0.176 | 51.3 | | | |
| | 50 | 0.036 | 0.158 | 57.3 | | | |
| Embodiment 9 | 10 | 0.479 | 0.308 | 19.0 | >80 times | <0.4 | 69 |
| | 20 | 0.349 | 0.296 | 22.1 | | | |
| | 30 | 0.275 | 0.253 | 33.4 | | | |
| | 40 | 0.238 | 0.196 | 48.4 | | | |
| | 50 | 0.209 | 0.171 | 55.0 | | | |
| Embodiment 10 | 10 | 0.221 | 0.315 | 21.3 | >60 times | <0.2 | 71.4 |
| | 20 | 0.188 | 0.295 | 26.3 | | | |
| | 30 | 0.162 | 0.273 | 31.8 | | | |
| | 40 | 0.146 | 0.255 | 36.3 | | | |
| | 50 | 0.134 | 0.244 | 39.0 | | | |
| Embodiment 11 | 10 | 0.098 | 0.365 | 13.1% | >30 times | <0.15 | 68.2 |
| | 20 | 0.071 | 0.345 | 17.9% | | | |
| | 30 | 0.064 | 0.321 | 23.6% | | | |
| | 40 | 0.049 | 0.299 | 28.8% | | | |
| | 50 | 0.041 | 0.286 | 31.9% | | | |
| Comparative example 1 | 10 | 1.152 | 0.395 | 1.3 | >100 times | >0.9 | 53.1 |
| | 20 | 0.965 | 0.372 | 7.0 | | | |
| | 30 | 0.854 | 0.299 | 25.3 | | | |
| | 40 | 0.842 | 0.265 | 33.8 | | | |
| | 50 | 0.798 | 0.246 | 38.5 | | | |
| Comparative example2 | 10 | 0.621 | 0.334 | 12.1 | >80 times | >0.4 | 67.1 |
| | 20 | 0.358 | 0.304 | 20.0 | | | |
| | 30 | 0.285 | 0.243 | 36.0 | | | |
| | 40 | 0.243 | 0.216 | 43.1 | | | |
| | 50 | 0.221 | 0.202 | 46.9 | | | |
| Comparative example3 | 10 | 0.545 | 0.295 | 1.7 | 1~2 times | <0.1 | 63.4 |
| | 20 | 0.407 | 0.272 | 9.3 | | | |
| | 30 | 0.33 | 0.199 | 33.7 | | | |
| | 40 | 0.284 | 0.165 | 45.0 | | | |
| | 50 | 0.254 | 0.146 | 51.3 | | | |
| Comparative example4 | 10 | 0.016 | 0.075 | 6.3 | >15 times | <0.1 | 46 |
| | 20 | 0.015 | 0.072 | 10.0 | | | |
| | 30 | 0.015 | 0.071 | 11.3 | | | |
| | 40 | 0.015 | 0.068 | 15.0 | | | |
| | 50 | 0.014 | 0.066 | 17.0 | | | |

As can be seen from Table 2, by comparing Embodiments 1, 3, 5 and 6, it can be known that increasing or decreasing the thickness of the liquid metal sheet layer has little effect on reusability, but it will increase thermal resistance. By comparing Embodiment 1 with Comparative examples 1 and 2, it can be known that although replacing the liquid metal sheet layer with copper foil or reticulated indium sheet of the same thickness can increase the numbers of the reusability, the overall thermal resistance will increase significantly. By comparing Embodiment 1 with Comparative examples 3 and 4, it can be known that if only graphene is used, although the thermal resistance is very low, the numbers of the reusability is only 1-2, and it cannot be reused. Using only liquid metal sheet layer as thermal conductive gaskets, the thermal resistance tested on a thermal resistance meter can reach a very low level. However, due to their extremely thin thickness and compression rate of less than 20%, they cannot fill the contact gap tolerance between the chip and the heat sink, thus making them difficult to apply.

The embodiments described above are part of the embodiments of the present disclosure, not all of them. The detailed description of the embodiments of the present disclosure is not intended to limit the scope of protection claimed the present disclosure, but merely indicates selected embodiments of the present disclosure. All other embodiments obtained by those ordinarily skilled in the art without making creative efforts based on the embodiments of the present disclosure fall within the scope of protection of the present disclosure.

## Claims

1. A composite thermal conductive gasket, comprising:
a graphene layer (200) oriented along a thickness direction, wherein the graphene layer (200) has a first surface and a second surface in the thickness direction, and the first surface is configured to adhered to a heat dissipation device (300);
a liquid metal sheet layer, wherein the liquid metal sheet layer is provided on the second surface of the graphene layer (200) and is capable of being bent towards sides of the graphene layer (200) and covering at least part of the sides of the graphene layer (200),
wherein the liquid metal sheet layer, from top to bottom, successively comprises a first alloy layer (101), an intermediate layer (102) and a second alloy layer (103), wherein materials of the first alloy layer (101) and the second alloy layer (103) are the same or different, and the intermediate layer (102) is a sheet-like thermal conduct material, and the sheet-like thermal conduct material comprises solid metal foil or a third alloy; and
a temperature of a melting point of the intermediate layer (102) is higher than those of the first alloy layer (101) and the second alloy layer (103).

2. The composite thermal conductive gasket according to claim 1, wherein a temperature difference between the temperature of the melting point of the intermediate layer (102) and the temperature of the melting point of the first alloy layer (101) is at least 50°C; or, the temperature difference between the temperature of the melting point of the intermediate layer (102) and the temperature of the melting point of the second alloy layer (103) is at least 50°C.

3. The composite thermal conductive gasket according to claim 2, wherein the solid metal foil comprises one or more of indium foil, platinum foil, copper foil, silver foil, aluminum foil and zinc foil;
and/or, the third alloy comprises one or more of the Cu-Al alloy, Cu-Sn alloy and Cu-In alloy.

4. The composite thermal conductive gasket according to claim 2, wherein the material of the first alloy layer (101) or the second alloy layer (103) comprises a phase change alloy or a low-melting-point alloy with the temperature of the melting point lower than 160°C;
optionally, the phase change alloy comprises one or more of the Ga-In-Sn alloy, In-Sn-Bi alloy, In-Bi alloy, In-Bi-Ga and Ga-In-Sn-Bi alloy.

5. The composite thermal conductive gasket according to claim 2, wherein a thickness of the liquid metal sheet layer is 20-200µm, wherein a thickness of the first alloy layer (101) and a thickness of the second alloy layer (103) are similar, and are 5-50µm;
optionally, the thickness of the graphene layer (200) is 0.3-3mm.

6. The composite thermal conductive gasket according to claim 1, wherein the liquid metal sheet layer covers a part or all of the sides;
and/or, the liquid metal sheet layer further covers a part or all of the first surface.

7. The composite thermal conductive gasket according to claim 1, wherein a side of the liquid metal sheet layer away from the second surface is provided with a copper plating layer or an aluminum plating layer.

8. A preparation method of the composite thermal conductive gasket according to any one of claims 1 to 7, comprising:
growing graphene on metal foils by chemical vapor deposition, and after the growth is completed, peeling off the graphene from the metal foils and stacking the graphene longitudinally to obtain the graphene layer (200) oriented along the thickness direction;
heating and melting the material of the first alloy layer (101) and the material of the second alloy layer (103) to form liquid metal, coating the liquid metal on opposite sides of a sheet-like thermal conductive material of the intermediate layer (102) to form the first alloy layer (101) and the second alloy layer (103), and then rolling an entire piece to obtain the liquid metal sheet layer; and
heating the liquid metal sheet so that the first alloy layer (101) or the second alloy layer (103) on a surface of the liquid metal sheet layer is in a molten state, then placing the graphene above the liquid metal sheet, and applying pressure to make the graphene closely contact the liquid metal sheet and pushing and pressing, after cooling under maintained pressure, obtaining the composite thermal conductive gasket.

9. The preparation method according to claim 8, wherein, after being rolled, the thickness of the first alloy layer (101) formed is 5-50µm, and the thickness of the second alloy layer (103) is 5-50µm;
or/and, the metal foil comprises one or more of copper foil, nickel foil, magnesium foil, iron foil, steel foil and titanium foil.

10. The preparation method according to claim 8, wherein the applied pressure is 20-30psi and a speed of pushing and pressing is 0.8-1.2mm/s.

11. A heat sink, comprising a heat dissipation device (300) and the composite thermal conductive gasket according to any one of claims 1 to 7, wherein the first surface of the composite thermal conductive gasket is adhered to the heat dissipation device (300).

12. The heat sink according to claim 11, wherein in the heat sink, the liquid metal sheet layer covers the second surface and the sides of the graphene layer (200) and extends outward, and two extended ends of the liquid metal sheet layer are respectively detachably connected to opposite sides of the heat dissipation device (300).

13. The heat sink according to claim 11, wherein in the heat sink, the liquid metal sheet layer covers the second surface, the sides and at least part of the first surface of the graphene layer (200), the liquid metal sheet layer further extends outward along the sides, and two extended ends of the liquid metal sheet layer respectively detachably connected to opposite sides of the heat dissipation device (300).
